# EUROPEAN PATENT APPLICATION

(11) **EP 1 067 830 A1**
(43) Date of publication of application: **10.01.2001**
(21) Application number: 99305458.4
(22) Date of filing: 09.07.1999
(51) Int. Cl.: H05K 3/00, C23F 1/08

(54) **A chemical solution treatment equipment**

(71) Applicant: Tokyo Kakoki Co., Ltd., Edogawa-ku, Tokyo (JP)
(72) Inventor: Niijama, Kisaburo, Edogawa-Ku, Tokyo (JP)
(74) Representative: Lyndon-Stanford, Edward Willoughby Brooke

(57) **Abstract**

This chemical treatment equipment comprises a tank (9) which can be filled with the same solution as the injected chemical solution (B); a conveyer(2) to transport the clamped substrate (A), mounted in the chemical solution (B) of tank (9); and a chemical solution injection device (10) such as a slit injection orifice (13) or spray nozzle (4) which injects the said chemical solution (B) toward to the substrate (A) to be transported with a very small spacing (L) between said jetting device and said substrate.

## Description

### Background of the invention

### Field of the invention

The present invention relates to a chemical solution treatment equipment. That is, for example, to be used in the manufacturing process of printed circuit boards. As for the transported substrate of printed circuit board, it relates to the chemical solution such as developing or etching chemical solution, and to the chemical solution treatment equipment which executing the chemical processing and chemical solution treatment.

### Brief description of the Prior Art

At first, the related technical background of a representing example of a substrate of the printed circuit board is description below. Recently, following by the prominent progress in the small size, lighted weight and high density of electrical machines, the important parts of the printed circuit board are also gradually progressed in compact size, fineness, very thinness and flexibility. For example, the ones which can be held as a related portion of printed circuit board, include the appearance of the semiconductor chip and package such as CSP, PBGA, therefore it gradually advances in the super compact size, super fineness, super thinness and super flexibility.

However, especially on this printed circuit board, the progress in the super fineness, super thinness and super flexibility in the circuits formed on its outer surface is under prominent situation.

Relatively, in the traditionally ordinary printed circuit board, a limit value of the circuit width is set to be about 150 microns. Even for the semiconductor chip's package winding as CSP, PBGA, the limit value of its circuit width is set to be about 70 microns. But, recently, due to the above description reasons, even the ordinary printed circuit board also is requested to have the circuit width about 50 microns to 30 microns. For example, it also is requested to have a 20 microns of circuit width and 30 microns of space between circuits.

As description above, for the circuit of the printed circuit board, its circuit width has tended to have a tendency toward very fineness, and simultaneously, the requirement in the tolerance of this circuit width is requested to be within 5%. The progress in its high precision and high density is also very prominent.

However, the above description printed circuit plate is fabricated by sequentially and continuously executing many processes such as cutting the printed circuit board which has the copper foil taped with insulation substrate; drilling the holes for through hole usage, grinding and electroplating; coating, drying or taping the etching resist; exposing the negative film for circuit usage; developing; etching; and peeling off the etching resist for circuit portions.

But, the developing process or etching process in this printed circuit board adopt a conveyer to horizontally transport the printed circuit board which is located in the chemical solution treatment equipment such as developing and etching devices. The developing and etching chemical solution are injected from many oppositely arranged spray nozzles to perform the chemical processing and/or chemical solution treatment to form the circuit.

However, in a printed circuit board as the above description progresses in very fineness, high precision and high density circuits, this chemical processing and chemical solution treatment such as developing and etching can be totally performed in uniformity. For example, uniformly executing the etching with high precision is very important, and it will affect the success of this process.

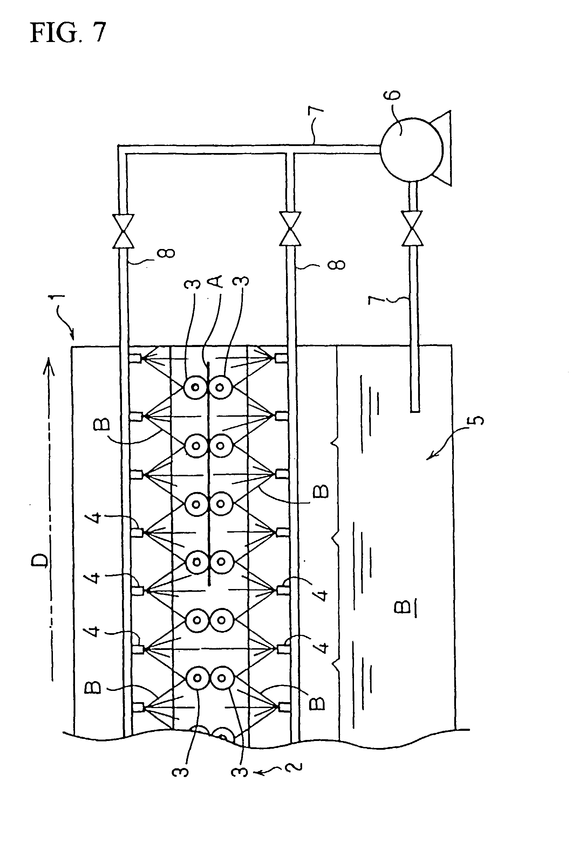

Fig. 7 is a side explanatory view that provides an explanation about this conventional example of the chemical solution treatment equipment. However, in the environment of processing chamber 1 of this conventional example of the chemical solution treatment equipment such as the developing device and etching device, the printed circuit board A used as a substrate is clamped between many up-down rollers 3 and wheels of the conveyer 2, and is transported horizontally.

However, for this transported printed circuit board A, a chemical solution B such as the developing and etching chemical solution is separately diffused in cone shape and/or gradually spread shape, and is injected out from many spray nozzles 4 which are arranged oppositely in an up-down whole area (fully covers large area of the whole body in a front-rear transporting direction and a left-right of a wide direction, and is arranged oppositely), to execute the chemical processing and chemical solution treatment such as developing and etching.

Further, after the chemical solution B injected from the spray nozzle 4 is passed through the outer surface of said printed circuit board A, it flows down to tank 5 for chemical solution control and is recovered. Then, the chemical solution B stored in the tank for chemical solution control is pressed and transferred to the spray nozzle 4 via pump 6, main pipe 7 and piping 8 again for future recycling usage.

### Subjects expected to be solved by the invention

But, as shown in Fig. 7, the chemical processing and/or chemical solution treatment such as developing and etching executed by the traditional chemical solution treatment equipment such as developing and etching devices is criticized to have the following questions.

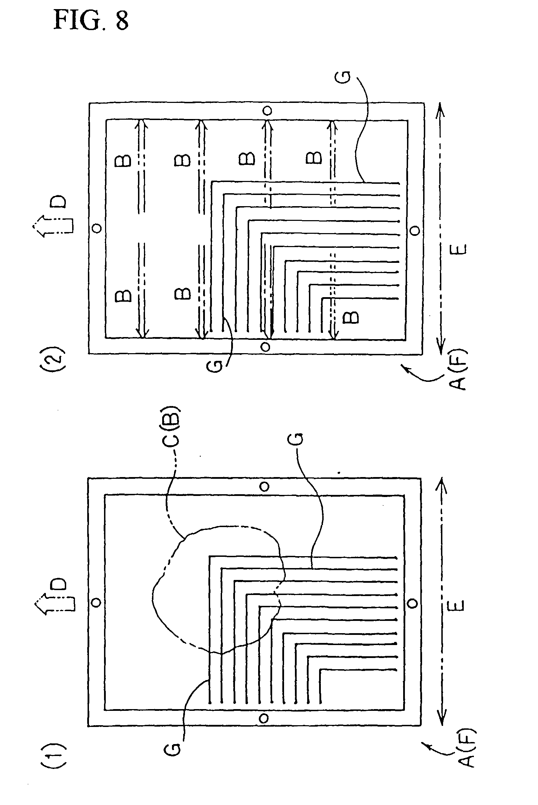

Firstly, the traditional example shown in the plan explanatory view of Fig. 8-(1) is that the chemical solution B injected from each spray nozzle 4 is offset-tarried in the upper central portion (the outer surface of the upper position) of the printed circuit board A, and tarried as a tarried chemical solution C. Therefore, it will cause damage to the uniformity for chemical processing and chemical solution treatment.

That is, in the environment, the chemical solution B injected to the upper central portion of the printed circuit board A became a dense tarried chemical solution C and tarried to encumber the replacement of the injected fresh chemical solution B; still, the old and low functional chemical solution B is tarried. Thus, owing to this tarried solution C of the chemical solution B, the chemical processing and chemical solution treatment in the upper central portion of the printed circuit board A is slow in speed and easy to become insufficient compared with two side portions of upper surfaces and back surface (lower outer surface).

Like this, the chemical solution treatment equipment such as the developing device and etching device according to the traditional example shown in Fig. 7, has suffered in the total uniformity of chemical processing and/or chemical solution treatment, thus became unstable. There will be locations of excessiveness and/or insufficiency where the phenomena of unbalance, accumulation and separation arise. Furthermore, the non-uniformity in circuit width will result in critical problems for the printed circuit board which is now advancing in very fineness, high precision and high density of circuit.

Secondly, the traditional example shown in the plan explanatory view of Fig. 8-(2) is that part of the chemical solution B injected from each spray nozzle 4 as the above description first one becomes a turbulent flow, flows toward a front-rear transportation direction D and tarried in the upper middle portion of printed circuit board A. But most of it on the outer surface of upper face and back surface of printed circuit board A flows in left-right wide direction, then from both the left and right sides of printed circuit board A flows down and out.

However, the result of the formation of this chemical solution B flow is criticized by the problem of a damage in uniformity of the chemical processing and chemical solution treatment.

That is, most of the injected chemical solution B from the spray nozzle 4 flows over the outer surface of printed circuit board A in left-right wide direction E. Therefore, for the printed circuit board A, a density of the fresh chemical solution B is low and its amount is low in the middle portion of the printed circuit board A (only the chemical solution B injected toward the middle portion is existed). As for the left side and right side portions, the density of the fresh chemical solution B is high and its amount is large (it will be the chemical solution B injected toward two side portions plus the chemical solution B flown from the middle portion).

Then, for the printed circuit board A, the chemical processing and chemical solution treatment corresponding to the central portion sides are slow in speed and insufficient, while the chemical processing and chemical solution treatment corresponding to the left-right side portions is fast in speed and over accelerated.

From this aspect, the chemical solution treatment equipment such as the developing and etching devices according to the traditional example shown in Fig. 7, is also criticized by the damage in total uniformity of the chemical processing and chemical solution treatment such as developing and etching. And, the chemical processing and chemical solution treatment become unstable. There will be locations of excessiveness and/or insufficiency where the phenomena of unbalance, accumulation and separation arise, thus causing the non-uniformity in circuit width. Therefore, it will become the critical problems for the printed circuit board, which is now advancing in very fineness of circuit, high precision and high density.

For example, the slow in speed and insufficiency of chemical processing and chemical solution treatment will result in that a circuit width becomes too wide. And, the rapid speed and over improvement of chemical processing and chemical solution treatment will result in that the circuit width is too narrow, and even the disappearance of circuits will occur.

Thirdly, hereby in this traditional example, at first, in order to solve the foregoing description first problem, an attachment of the chemical solution treatment equipment as Fig. 7 is adopted to proceed, such as each nozzle 4 injecting the chemical solution can be a head swing mechanism which reciprocally swings head and/or an oscillation mechanism that reciprocally slidably moves in a left-right direction on a horizontal plane. Further, a reverse mechanism attached to the chemical solution treatment equipment as Fig. 7, is adopted to move the transported printed circuit board A up and down in the mid-way and rotate its surface and back surface by 180 degrees.

And, by using the head swing mechanism, oscillation mechanism and reverse mechanism here, it can improve appreciably for the problem of the tarried solution C on the central portion of upper surface of printed circuit board A. For the printed circuit board that is now advancing in the very fineness, high precision and high density, still it wishes to have a situation of complete and essential solution. Further, the new problems such as the increase in equipment cost and a need of setup space owing to the addition of the above description mechanism are also criticized.

In addition, in order for this traditional example to solve the foregoing description second problem, an attachment of the chemical solution treatment equipment as Fig. 7 is adopted to proceed, such that a turning mechanism which can switch the transported printed circuit board A to left or right 90 degrees during transportation, also executes a switch between the left-right wide direction E and front-rear transportation direction D.

And, although by this turning mechanism, the slow in speed and insufficiency for the chemical processing and chemical solution treatment in the central portion of printed circuit board A can be improved. But, for the printed circuit board that is now advancing in the very fineness, high precision and high density, still it wishes to have a situation of complete and essential solution. Further, the problems such as the increase in equipment cost and a need of setup space owing to the addition of the above description mechanism are also criticized.

Fourthly, the chemical solution treatment equipment such as the developing and etching devices according to the traditional example shown in Fig. 7, is that the solution B injected from each spray nozzle 4 happens to be spread to many locations on the transported printed circuit board A on the roller 3 and wheel of conveyer 2. Therefore, It is hard to be emitted directly to the outer surface of the sprayed object as printed circuit board A.

According to above description, the fresh chemical solution B is sprayed and spread. There is directly and effectively injection to the outer surface of printed circuit board A, such that the impact is insufficient, thus encumbers replacement of the chemical solution B on the outer surface of printed circuit board A. Therefore, the chemical processing and chemical solution treatment such as developing or etching on the outer surface of printed circuit board A may become totally slow. These portions of adoption problems for low processing capability and producing efficiency are criticized.

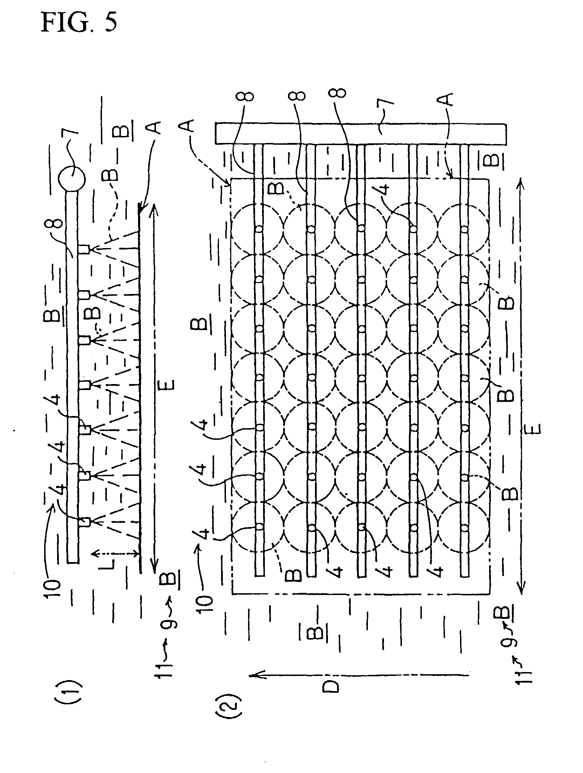

Fifthly, the chemical solution treatment equipment such as the developing and etching devices according to the traditional example shown in Fig. 5, Fig. 7, is that the solution B injected from each spray nozzle 4, is tarried on the upper surface (the outer surface of upper position) of printed circuit board A. Hereby, the foregoing described tarried solution C will occur. Beside this problem, it is also criticized by the problem such as the bending or spring back of the printed circuit board A due to the weight of the tarried chemical solution B.

That is, the transported printed circuit board A which is now advancing in the super thinness and flexibility, is clamped between each roller 3 and wheel in up-down of the conveyer 2 and located between every front-rear rollers and left-right wheels. And it is easy to be slightly bent concavely due to the weight of chemical solution tarried on the injected surface. Thus, the transported printed circuit board A is bent due to the above described bending of the bending end. This sometimes becomes the obstacles for smooth transportation.

In general, the occurrence of obstacles in the transportation of the printed circuit board A in conveyer 2 will cause the non-smooth execution of the chemical processing and chemical solution treatment. Thus, this becomes the reason of defect and causes the yield problem.

Sixthly, in the environment of its processing chamber of the chemical solution treatment equipment as developing device and etching device of traditional example shown in Fig. 7, for the printed circuit board A transported on the conveyer, the chemical solution B from each spray nozzle 4 is diffused, mist-sprayed and spread in cone shape or gradually widened end shape.

Hereby, from the chemical solution B such as developing and etching chemical solution, e.g., large amount poisonous gas is created because of the gasification of a vaporization of oxidant. Thus, the gas occurred needs to be exhausted to the exterior from the processing chamber 1 by an exhausting mechanism. This portion of problems such as the increase in equipment cost and a need of setup space owing to the addition of the above description mechanism are criticized.

Further, large amount is occurred from the chemical solution B such as injected developing and etching chemical solution. These portions of problems such as the consumption of chemical solution B, the slow in speed in the total chemical processing and chemical solution treatment, bad adoption problems for low processing capability and producing efficiency are also criticized.

By reviewing these real situations, the present invention wants to solve the above describing subjects of the traditional examples. This result is due to the research effect of the inventor. The inventor sees through the limit of prior art in the sense to improve the essential technology. In the chemical solution tank, the substrate as the printed circuit board is transported on the conveyer, then the fresh chemical solution is sprayed via the spray nozzles and the silt shaped injecting orifices of the chemical solution injecting device. Firstly, the tarry of chemical solution is eliminated to achieve the uniformity in chemical processing and chemical solution treatment. Secondly, the chemical solution flowing toward left-right wide direction is eliminated. Thus, from this aspect, the uniformity in chemical processing and chemical solution treatment are also achieved. Thirdly, it can realize the benefits in the aspects of the equipment cost and layout space. Fourthly, there is no chemical solution spraying and to rollers and wheels of the conveyer, and spreading. Therefore, the processing capability of the chemical processing and chemical solution treatment is upgraded. Fifthly, the bending of spring back of the substrate of the printed circuit board is eliminated to realize the smooth transportation. Sixthly, by providing the chemical solution processing equipment such as developing device and etching device, the gasification of the injected chemical solution is also prevented.

### Means to solve the issues

The technical means of the present invention which solve these issues are as following. Firstly, a chemical solution treatment equipment according to claim 1 executes a chemical processing by injecting the corresponding chemical solution to the transported substrate.

And, it is characterized in that: the injecting chemical solution and chemical solution tank full of the same chemical solution; a conveyer mounted in the chemical solution of the chemical solution tank to transport the substrate; and a chemical solution injection equipment injects the said fresh chemical solution toward to the transporting substrate mounted in the chemical solution of the chemical solution tank.

The claim 2 is as following. That is, the chemical solution treatment equipment of this claim 2 is that a chemical solution treatment equipment as description in claim 1, wherein the said conveyer is provided with many up-down rollers or wheels to clamp the substrate for transportation, and is characterized in that a chemical solution injection equipment is mounted in the front-rear intervals between rollers and wheels of the said conveyer, and the corresponding transporting substrate exists in the very small up-down interval and arranges oppositely.

The claim 3 is as following. That is, the chemical solution treatment equipment of this claim 3 is that a chemical solution treatment equipment as description in claim 1, wherein the said chemical solution treatment equipment is used for manufacturing process of printed circuit boards, and is characterized in that a substrate is a printed circuit board material with circuits formed on its outer surface; and a chemical solution is used as the developing chemical solution and etching chemical solution.

Next, the claim 4 is as following. That is, the chemical solution treatment equipment of this claim 4 is that a chemical solution treatment equipment as description in claim 1, wherein the said chemical solution treatment equipment uses the many spray nozzles, and is characterized in that spray nozzles corresponding to the transported substrate cover a large area of the whole body in a front-rear transporting direction and a left-right of a wide direction, put at fixed front-rear and left-right pitch in between, and arrange oppositely.

The claim 5 is as following. That is, the chemical solution treatment equipment of this claim 5 is that a chemical solution treatment equipment as description in claim 1, wherein the said chemical solution treatment equipment uses the slit shaped injection orifice, and is characterized in that a slit shaped injection orifice corresponding to the transported base material covers not only a front-rear transporting direction but also a left-right of a wide direction, and arranges oppositely.

The claim 6 is as following. That is, the chemical solution treatment equipment of this claim 6 is that a chemical solution treatment equipment as description in claim 5 is characterized in that a slit shaped injection orifice of the chemical solution treatment equipment not only diffuses the chemical solution to the whole width of the substrate, and also injects it straightly and in longitudinally flat curtained type.

Next, the claim 7 is as following. That is, the chemical solution treatment equipment of this claim 7 is that a chemical solution treatment equipment as description in claim 4, 5 and 6, wherein the chemical solution tank is mounted in its upper part and the chemical solution managing reservoir is mounted in its lower part.

And, it is characterized in that said chemical solution injected from the spray nozzle and slit shaped injection orifice of the chemical solution injection equipment is passed through the outer surface of said substrate, then the overflow from said chemical solution tank flows down to the chemical solution managing reservoir for recovery; said chemical solution stored in the chemical solution managing reservoir is pressed to the spray nozzle and slit shaped injection orifice of the chemical solution treatment equipment via pump and pipe for recycling usage.

The present invention has become of this kind and as following. This chemical solution treatment equipment has said conveyer which the substrate of the printed circuit board is clamped between many up-down rollers or wheels and transported, and the chemical solution injecting device which injects the chemical solution as developing chemical solution and etching chemical solution.

A chemical solution injection device is arranged in the front-rear intervals between rollers and wheels of the said conveyer, and corresponding to the substrate of transported circuit board is oppositely arranged only in up-down intervals. And this chemical solution injection device uses the spray nozzles or slit shaped orifices to spray the chemical solution in straight curtain shape.

And, this chemical solution treatment equipment is that the conveyer and the chemical solution injecting device are arranged in the chemical solution tank but not in the environment as its characteristic. Thereby, the fresh chemical solution is injected by the chemical solution injecting device to the substrate of transported printed circuit board via a conveyer in the chemical solution which is tarried in the chemical solution tank.

Hereby, corresponding to the substrate of transported printed circuit board, there are no occurrence of accumulation and no flow in left-right wide flow direction and are uniform, along with directly, effectively and impact to inject without gasification. Further, the substrate of printed circuit board will not bend up which is caused by the weight of injected chemical solution. Thus it can be transported smoothly.

This chemical solution treatment equipment executes the chemical processing and chemical solution treatment as developing and etching to from the expected circuit on the outer surface of printed circuit board.

Still, the chemical solution treatment equipment has arranged the chemical solution tank in its upper portion and the chemical solution managing reservoir in its lower portion.

And, the chemical solution is injected to the substrate of transported circuit board in the chemical solution tank. The chemical solution injected from the spray nozzle and slit shaped injection orifice of the chemical solution injection device is passed through the outer surface of said substrate. Then, the overflow from said chemical solution tank flows down to the chemical solution managing reservoir for recovery. Further, the chemical solution stored in the chemical solution managing reservoir is pressed to the spray nozzle and slit shaped injection orifice of the chemical solution treatment equipment via pump and pipe for recycling usage.

### Brief description of the drawings

Fig. 1 is a front explanatory section view providing an explanation that shown the implementation status related to the chemical solution treatment equipment of the present invention, and is a section view in the direction of arrow along line I-I in Fig. 3;
Fig. 2 is a front explanatory section view providing an explanation that shown the implementation status of the present invention, and is a section view in the direction of arrow along line II-II section view Fig. 3;
Fig. 3 is an explanatory side view providing an explanation that shown the implementation status of the present invention;
Fig. 4-(1) is a side section view, Fig. 4-(2) is a front view, and Fig. 4-(3) is a bottom view of slit shaped injection orifices of the chemical solution injection equipment to provide an explanation that shown the implementation status of the present invention;
Fig. 5 -(1) is a side section view, and Fig. 5-(2) is a plan view of spray nozzles of the chemical solution injection equipment to provide explanations that shown the implementation status of the present invention;
Fig. 6-(1) is a schematic plan view of another example of slit shaped injection orifices of the chemical solution injection equipment, Fig. 6-(2) is a schematic plan view of another example of spray nozzles of the chemical solution injection equipment, and Fig. 6-(3) is a schematic plan view of further another example of spray nozzles of the chemical solution injection equipment to provide explanations that shown the implementation status of the present invention;
Fig. 7 is a side explanatory view providing an explanation of a corresponding prior example of this chemical solution injection equipment;
Fig. 8-(1) is an explanatory plan view providing an explanation of a corresponding prior example of this printed circuit board (substrate) that shown the tarried chemical solution, and Fig. 8-(2) is an explanatory plan view providing an explanation of a corresponding prior example of this printed circuit board (substrate) that shown the flow to the left and right;
Fig. 9-(1) is a plan explanatory view, and Fig. 9-2(2) is a front explanatory view providing an explanation of a printed circuit board (substrate) that shown the implementation status of the present invention.

### Detailed description of the invention

### Embodiments of the invention

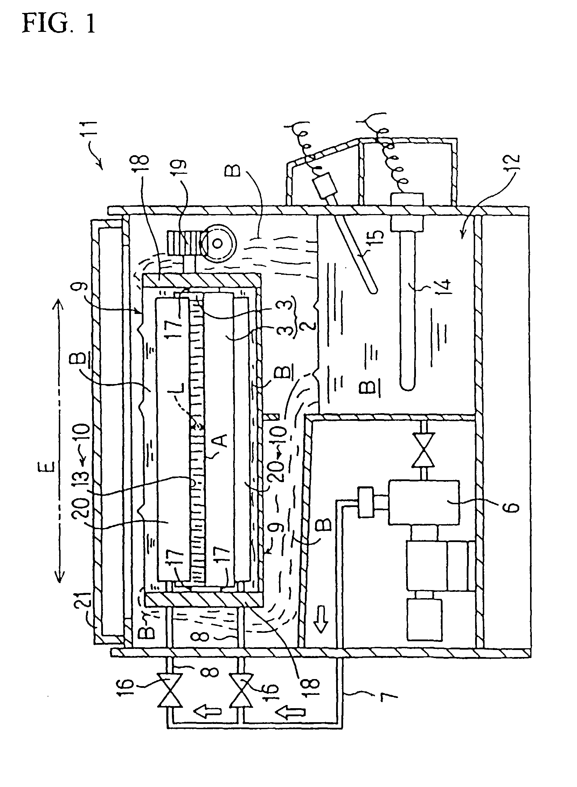

The present invention is explained in detail based on the following embodiments of the invention shown in figures. Figures 1, 2, 3, 4, 5, and 6 provide the explanation of the embodiments of chemical solution treatment equipment according to the present invention.

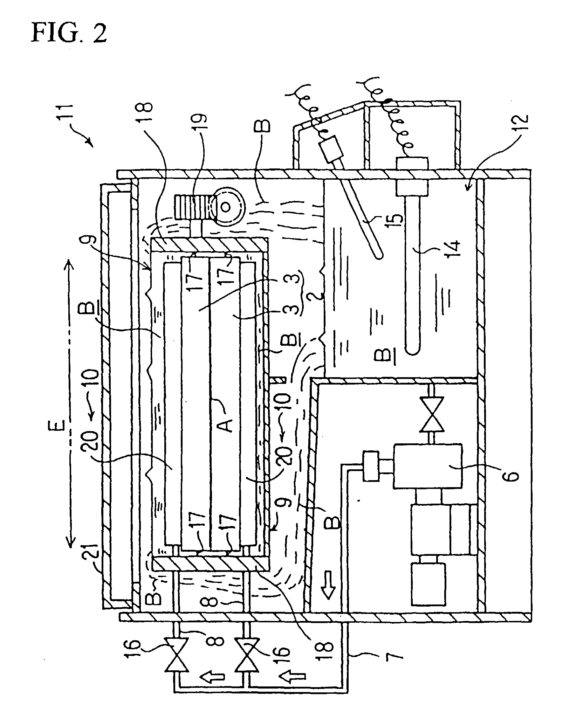

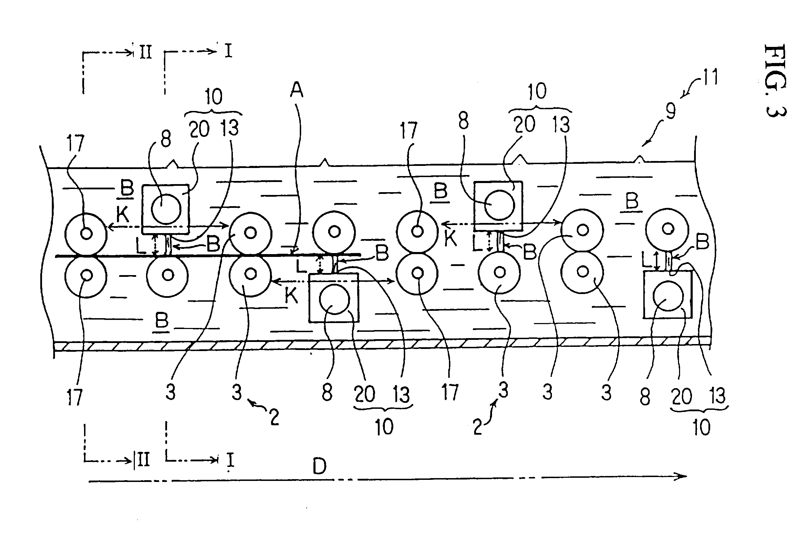

And, Fig. 1 is a front explanatory section view, and is a section view in the direction of arrow along line I-I in Fig. 3. Fig. 2 is also a front explanatory section view, and is a section view in the direction of arrow along line II-II section view Fig. 3. Fig. 3 is an explanatory side view.

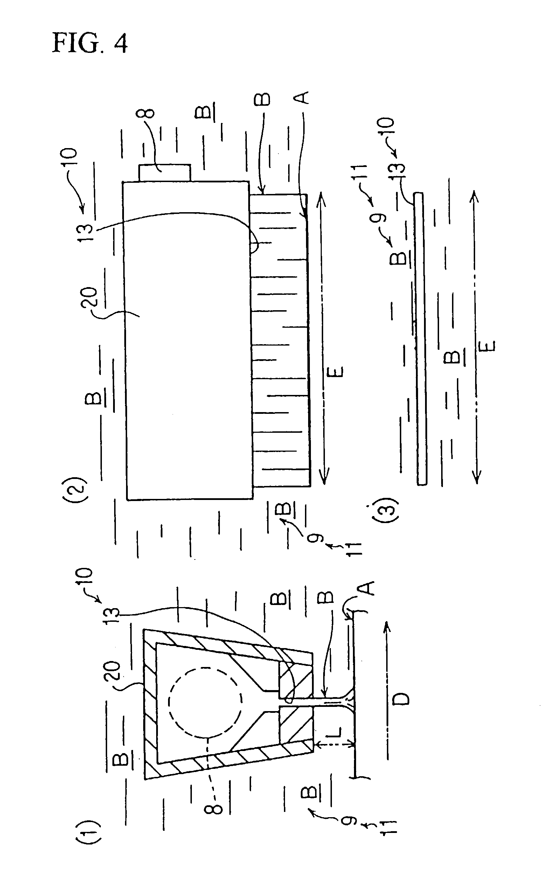

Fig. 4-(1) is a side section view, Fig. 4-(2) is a front view, and Fig. 4-(3) is a bottom view shown the many slit shaped injection orifices of the chemical solution injection equipment.

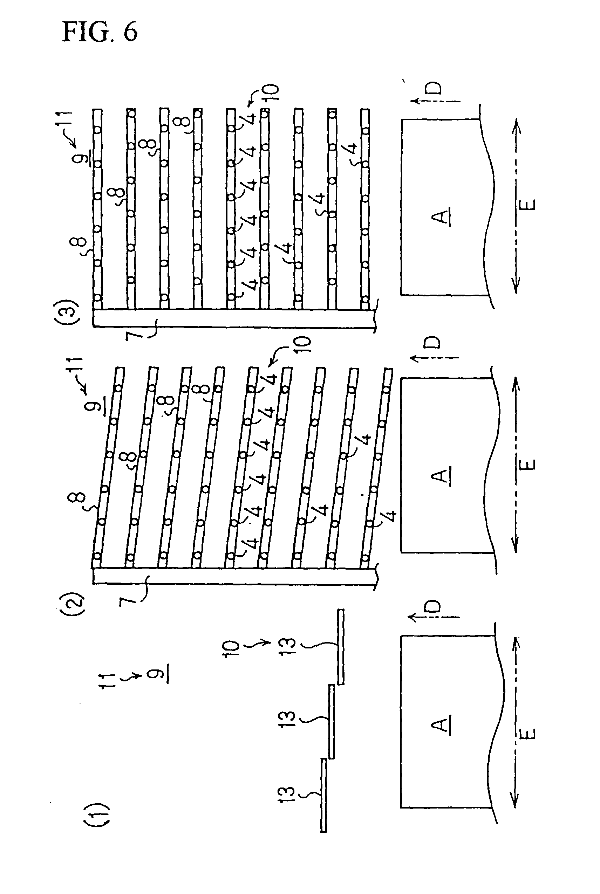

Fig. 6-(1) is a schematic plan view of another example of slit shaped injection orifices of the chemical solution injection equipment, Fig. 6-(2) is a schematic plan view of another example of spray nozzles of the chemical solution injection equipment, and Fig. 6-(3) is a schematic plan view of further another example of spray nozzles of the chemical solution injection equipment.

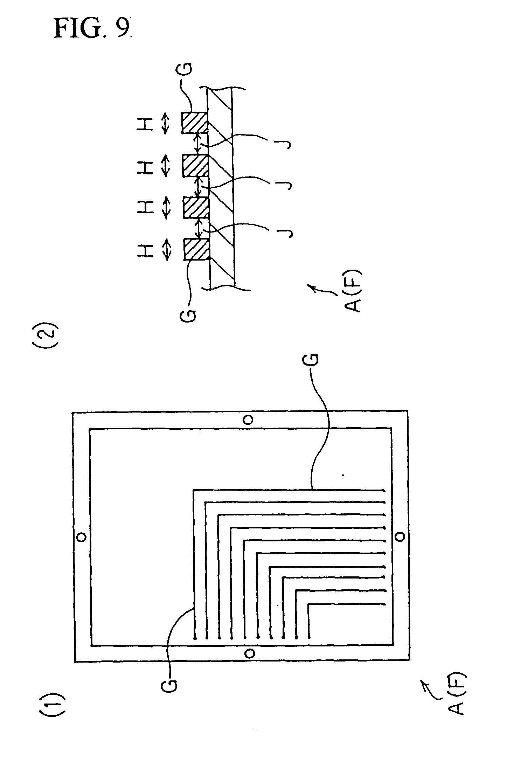

Furthermore, Fig. 9-(1) is a plan explanatory view, and Fig. 9-2(2) is a front explanatory view providing an explanation of a printed circuit board (substrate).

This chemical solution treatment equipment is used for the manufacturing, machining and the other processing procedures. Hereby, the circumstance of the usage of manufacturing procedure is description in detail. At first, the foregoing printed circuit board F is referred to the Fig. 9, and then explained.

The printed circuit board F has all kinds of usage as the boards of all kinds of OA machines, boards for personal computers, boards of calculators and boards for all kinds of the other electronic machines along with the development of multimedia. Thus there are also variety of manufacturing procedures. The printed circuit board F is classified into one for all, single sided board, double sided board, multi-layered board(including the one made by recent build-up method) and flexible board. One of these recently is wound with the appearance of CSP, PBGA of the semiconductor chip package.

And, the printed circuit board has significantly progressed in compact size, light weight, fineness, flexibility and multi-layers in recent years, especially in the super fineness, high precision and high density of circuits formed on the outer surfaces.

And, the printed circuit board F, e.g., is fabricated by the following. That is, the printed circuit board F uses printed circuit plate as its base material and is fabricated by sequentially and continuously executing many processes as ordering, layering, grinding, cutting; drilling, grinding and electroplating the holes for through hole usage; coating, drying or taping the etching resist; exposing the negative film for circuit usage; developing; etching; and peeling off the etching resist for circuit portions...etc.

From here, it is description further in detail. At first, the two sides of insulation substrate as polyimide has executed the washing and grinding after the extended assembly of deposition by the hot press of copper foil. Thus, along with the executing soft etching to roughen the copper surface. For example, the printed circuit board A of deposition plate by extending the two sided copper foils ahs cut into work sized pieces. Next, after executing the drilling of through holes, the washing and two sides' grinding are executed, then the panel electroplating. Via this, the electroplating for the back wall of through hole is executed to make conduction between the out and back surfaces of circuit G.

(However, there are situations that use only single sided copper foils of deposited plates attached with single sided copper foils of insulation substrate. In this situation, the painting, exposing and developing of the foregoing light sensitive resist is also executed on single side only. It is no need to say that the present invention is also suitable for the printed circuit board A of the usage of this single board.)

Many through holes (by hundreds or thousands) of very small diameters are formed in one printed circuit board A.

From that, the printed circuit board A executes washing, grinding, washing and drying once more. Then, the membrane painting process for the light sensitive resist etching resist (i.e. the protective membrane with alkali-resitivity and acid-resitivity) is executed by painting to dry.

Thereafter, the picture of circuit G with its negative film has been exposed to leave the exposed and hardened portion of circuit G of the light sensitive resist on the forming surface of upper and lower outer surfaces. The other unwanted portion solved, removed and etched by the injection of the developing chemical solution of chemical solution B (also referred to the following description Fig. 1 and Fig. 3.).

After that, this light sensitive resist is hardened, and leave the copper portion of circuit G which is over-coated and protected by executing the cleaning and drying of the printed circuit board A. The unwanted portion of copper by solving and removing the foregoing light sensitive resist, is solved, removed and etched by the injection of the etching chemical solution of chemical solution B (also referred to the following description Fig. 1 and Fig. 3).

Thereafter, the remaining light sensitive resist of the foregoing hardened circuit G portion is cleaned and dried after being solved and removed by the injection of peel-off chemical solution B. Thus, it is able to obtain the printed circuit board F with the designated circuit G

Printed circuit board F, e.g. has the dimensions (length by width) of 550 millimeters (mm) by (X) 550 millimeters (mm), 500mm X 500mm or 500mm X 300mm. Its thickness, e.g. is 0.06mm in the insulated substrate portion. For example, the circuit G potion made of copper can reach as thin as 0.018mm thickness.

Even for a four layered multi-layers board, the thickness of a whole body for this printed circuit board F is from 1 mm to 0.8mm, further can be 0.4mm, such that can achieve the super thinness.

In addition, the circuit width H can reach the range from 150 microns to 70 microns, even more to 40 microns, and has a tendency to achieve super fineness. The circuit width H of 20 microns also appears to have about 30 microns of knees in the space J between circuits.

Still, the printed circuit board F fabricated by this procedure is related to be formed by the post processing procedure which forms one of this manufacturing procedure, and is used to form a protective membrane of the formed circuit G.

That is, in the total forming surface of circuit G of an outer surface of the printed circuit board F, the painting membrane process is executed by the painting and drying of the solder resisted light sensitive resist. Then, the exposing and developing for negative film is executed. Thus, the part mounting portion of through hole portion, generally, only the patterned light sensitive resist is solved and removed to exposure (the procedures hereof uses the foregoing procedures as standard).

This circuit G is protected by the membrane which is formed in the light sensitive resist on the printed circuit board F. However, after this, the circuit G of the printed circuit board F is protected by pattern attaching which is executed corresponding to the mounting portion of parts. The printed circuit board F is fabricated by this procedure.

The chemical solution treatment equipment according to the present invention will be explained below with reference to the Figures 1, 2, 3, 4, 5 and 6.

The chemical solution treatment equipment as this developing device and etching device are, e.g., used for manufacturing procedures as the developing procedure and etching procedure of the foregoing printed circuit board F. The developing chemical solution and etching chemical solution of chemical solution B are injected to the thin plate shaped substrate of the printed circuit board A which is transported horizontally by a conveyer 2. Further, the chemical processing and chemical solution treatment as developing and etching are executed to form the circuit on the outer surface of printed circuit board A.

Thus, the chemical solution treatment equipment as shown in Fig. 1, Fig. 2, Fig. 3 have the injected chemical solution B and the chemical solution tank 9 filled with the same chemical solution B; the conveyer 2 used for transporting the substrate of the printed circuit board A which is arranged in the chemical solution B of chemical solution tank 9; and the chemical solution injecting device 10 injecting the fresh chemical solution B toward the transported substrate of printed circuit board A which is arranged in the chemical solution B of chemical solution tank 9.

Hereafter, more is further description in detail. At first, the total arrangement of chemical solution treatment equipment is description as shown in Fig. 1, Fig. 2, and Fig. 3. The chemical solution tank 9 is mounted in the upper portion of processing chambers 11 as developing chamber and etching chamber, and the reservoir 12 is mounted in the lower portion of processing chamber 11.

Therefore, the chemical solution B injected from the spray nozzle 4 (the example in Fig. 5) and the slit shaped injecting orifice 13 (the example in Fig. 1, Fig. 2, Fig. 3 and Fig. 4) are flown down from chemical solution managing reservoir 12 due to the overflow from chemical solution tank 9, and recovered after being flown through the outer surface of printed circuit board A. The chemical solution B tarried in the chemical solution managing reservoir 12 executes this concentration management and temperature management, and uses a re-pump 6, a out pipe of main pipe 7 and the piping 8 manifolded from main pipe 7 as the interface press and feed toward the spray nozzle 4 of chemical solution injecting device 10 and slit shaped injecting orifice 13 for recycling.

In Fig. 1, Fig. 2, the 14, the heater is mounted in the chemical solution managing reservoir. The 15 is a concentration sensor of the chemical solution B. The 16 is the pressure adjusting valve mounted in piping 8. Still, the chemical solution managing reservoir 12 is not in the lower portion of processing chamber 11 shown in these figures. But it also can be set in a location with lower height than that of a chemical solution tank 9 within the processing chamber 11. The whole layout of chemical solution treatment equipment becomes this kind.

Next, the conveyer 2 of chemical solution treatment equipment is description. The conveyer 2 located in the chemical solution treatment equipment shown in Fig.2, Fig. 3 are provided with multiple up-down rollers 3 and wheels (not shown in figures). The substrate of printed circuit board A is clamped and transported horizontal in transporting direction.

And, the conveyer 2 is mounted in the chemical solution B of chemical solution tank 9. Several or many shafts 17 arranged horizontal in fix-spaced pitch are in the front-rear transporting direction D which is parallel with the left-right width direction E. The roller 3 mounted on each shaft 17 is prepared.

And, the roller 3 mounted on each shaft 17 is up-down arranged oppositely to clamp the printed circuit board A. In addition, The upper sided (lower sided) shaft 17 and roller 3 are rotated drive. The lower sided (upper sided) shaft 17 and roller 3 function as pushing and preventing the snake motion.

Still, instead of roller 3, it is also good enough with wheels attached in designated intervals of each shaft. Fig. 18 is a conveyer frame with driving gear 19. The conveyer 2 becomes this kind.

Next, we describe the chemical solution injecting device 10 of this chemical solution treatment equipment. Further, the chemical solution injecting device 10 of Fig. 3 as those shown in Fig. 1 together with rollers and wheels of a conveyer 2 are arranged between the front-rear intervals K. The horizontally transported printed circuit board only exists in the up-down interval L and is arranged oppositely.

And, the roller 3 and wheels which is put in the chemical solution B of a chemical solution tank 9, are arranged in designated pitch in the front-rear transporting direction. The examples shown in drawings are put in a proper position where the space equal to one piece of front-rear interval K is formed. Then, the chemical solution injecting device 10 is arranged within this front-rear interval K.

Furthermore, every 3 rollers together form these front-rear intervals K. The upper roller 3 and lower roller 3 together from this front-rear interval K. And, the upper front-rear interval K and lower front-rear interval K is formed by offset in rear-front of the up-down relative position. The many chemical solution injecting devices 10 are mounted between each front-rear interval K.

In addition, the tip of this chemical solution injecting device (the upper end or lower end of spray nozzle 4 and slit shaped injection orifice 13) for the printed circuit board is under 10mm representatively, e.g., is positioned at about 5mm of the up-down interval L (the traditional example in foregoing description Fig. 7 becomes about 150mm). Still, the up-down interval L is ranged from 20mm to 1 mm, and can have all kinds of possible setting.

And, the chemical solution injecting device 10 shown as examples in Fig. 1, Fig. 2, Fig. 3 and Fig. 4 uses many slit shaped injecting orifices 13. The example shown is Fig. 5 uses the spray nozzle 4.

Firstly, we describe the slip shaped orifice 13. This slip shaped orifice 13 is different from the spray nozzle 4 used in this traditional example foregoing description in Fig. 7. Corresponding to the substrate of transported printed circuit board A, it covers the left-right wide direction but not front-rear transportation direction D. And, it is arranged oppositely in the chemical solution B of chemical solution tank 9.

And, the chemical solution B press-fed via pump 6 did not diffuse but straight in a vertical and slight flat shaped curtain, but transport the printed circuit board A in full width horizontally.

We further describe this slit shaped injecting orifice 13 in detail. The chemical solution injecting device 10 as shown in Fig. 4 has one end been connected with the piping 8 and the other end been closed. The hollow pipe body 20 is arranged along the wide direction E, and has the very thin front-rear gap formed as slit shaped orifice 13 is which is the lower end center line (thing in upper side) or upper end center line (thing is lower line) of the pipe body 20.

This slit shaped orifice 13 has no fine front-rear gap and the linear gap and groove; its transportation direction D is not along the front-rear direction but along left-right wide direction E; and is arranged in a chemical solution tank 9. And, when the printed circuit board A is arranged in an upper position, the up-down interval L between lower end and the upper surface of printed circuit bas plate is set to be about 10mm. When the printed circuit board A is arranged in an upper position, the up-down interval L between upper end and the lower surface of printed circuit board is set to be under 10mm.

And, the chemical solution B pressed in, supplied and filled from the piping 8 of the pipe body 20 is injected from the slit shaped injection orifice 13 put in the chemical solution B of a chemical solution tank 9 with a curtain shape. Hereby, about this slit shaped orifice 13, each of the following example is considered.

Firstly, the slit shaped orifice 13 and chemical solution injecting device 10 shown in Fig.3 and Fig.1, Fig.2 is that the printed circuit board is oppositely up-down arranged. Hereby, also consider only the up-down shift oppositely arranged. However, only for roller 3's up-down shift, the designated front-rear interval K is formed. This formed front-rear interval K also considers the arrangement of chemical solution injecting device 10 with slit shaped injection orifice.

In particular, by the two faces board of the drawing example, while under the circumstance of single faced board which the circuit G is formed in only single faced board A.

Secondly, the slit shaped orifice 13 and chemical solution injecting device 10 shown in Fig. 3 is separately put in up-down and exists the intervals in transportation direction D by the odd numbered arrangement. However, it is also possible to be arranged one by one is also possible to be arranged one by one at only one location for up-down roller 3. That is, the front-rear interval K is formed only in one location in up-down roller 3. The chemical solution injection device as slit shaped injection orifice 13 is also possible is arranged separately one by one.

Thirdly, the slit shaped orifice 13 and chemical solution injecting device 10 shown in Fig.3 and Fig.1, Fig.4 is one by one set with one long front-rear interval K separately in left-right wide direction E. Hereby, those shown as Fig.6-(1), e.g., is also possible to be divided into 3 short intervals separately in left-right wide direction E. Generally under this situation, each ends of the divided each slit shaped injecting orifice 13 and chemical solution injection device 10 is connected with the ends of piping 8 which is manifolded.

Fourthly, the slit shaped orifice 13 and chemical solution injecting device 10 shown in Fig.4 is that However, these drawing examples has certain inclination in front-rear corresponding to left-right wide direction E. It is also good to be arranged as the slit shaped orifice 13 and chemical solution injecting device 10.

Fifthly, the slit shaped orifice 13 and chemical solution injecting device 10 shown in Fig.3, Fig.4 is that the injection angle corresponding to printed circuit board A is set to squared angle. In general, corresponding to printed circuit board A transported in horizontal gesture, the slit shaped orifice 13 has the angle setting to inject the curtain shaped chemical solution B from longitudinal direction.

Corresponding to this, by this drawing example, the injecting angle corresponding to printed circuit board A is possible to be set as with certain inclination in front-rear from an square angle. In general, the curtain shaped chemical solution B is also possible to be injected to the printed circuit board by a inclined injecting angle in front-rear slanted direction slightly from square angle.

This inclined injecting angle is set to only some angle, e.g., is set to about an injecting angle of 5 degrees. It is also possible to have its lower limit as 1-2 degrees, as for the upper limit is about 10 degrees.

Still, the slit shaped orifice 13 which is inclined in the down stream side of transportation direction D, has an incident angle to printed circuit board which is set to an obtuse angle in upstream side and acute angle in downstream side. Or contrary to this, it is also good to have an incident angle to printed circuit board which is set to an acute angle in upstream side and an obtuse angle in downstream side.

Sixthly, the up-down interval L between the slit shaped orifice 13 of chemical solution injecting device 10 and printed circuit board A is less than 10mm, e.g., is set to 5mm. This up-down interval L also considers to be variant.

In general, the horizon printed circuit board A with certain levels is used in solution injection device 10, the level of chemical solution injecting device 10 and slit shaped injecting orifice is changeable. Thus, the up-down interval L can be changed to 3mm, 4mm, 5mm, 6mm, 7mm, and will be considered.

Next, the spray nozzles for the chemical solution device 10 is description. As for the chemical solution injection device 10, the height level of slit shaped injection orifice. The above descriptions of Fig.1, Fig. 2, Fig. 3, Fig. 4-(1). Fig. 4-(2), Fig. 3-(1), Fig. 6-(1) according to the spray nozzle Fig. 5-(1), (2), Fig. 6-(1), (2) is also possible to use spray nozzle 4.

And, this spray nozzle 4 corresponding the transported printed circuit board A is the same as the traditional example of the foregoing description Fig. 7 to totally cover a wide area of the front-rear transportation direction D and left-right wide direction E, and one by one is put in left-right with a designated interval pitch and oppositely arranged. It is different from the foregoing description traditional example of Fig.7. It is oppositely arranged in the chemical solution B of the chemical solution tank 9.

This spray nozzle 4 is further description in detail. This chemical solution injection device 10 is shown as Fig.5, which has one end to be manifold-connected with main pipe 7 and the other end to be closed separately; the multiple piping 8 to be parallel in wide direction E (spray pipe, injection type) and the multiple piping 8 has the spray nozzles 4 to be formed in multiple by designated interval pitch.

This spray nozzle 4 is rotated by a square angle from the front-rear transportation direction D to left-right wide direction E, then one-by-one put by designated pitch interval in front-rear-left-right and arranged by large numbers in the chemical solution tank 9.

And, it is pressed into the main pipe 7 from piping 8. The provided chemical solution B is put in chemical solution B of the chemical solution tank 9, and is diffused and sprayed to transported printed circuit board from each spray nozzle 4.

Hereby, as for the arranged points for these chemical solution injection device 10 and spray nozzle 4 in chemical solution B of the chemical solution tank 9, the point of up-down interval L between spray nozzle 4 and printed circuit board A, the point which only up-down shift of printed circuit board A arranged oppositely is also possible, the point of inclination setting of injection angle, the point which the setting of up-down interval L is possible, and the like, when the chemical injection device 10 and slit shaped orifice 13 are used, it will be based on the foregoing description, thus we omit this explanation.

Corresponding to this, as the example of Fig. 3, the slit shaped orifice 13 protruded from the chemical injection device 10 is arranged at front-rear interval K formed by every the 3 rollers along the transportation direction D. When using the spray nozzle 4 and the chemical injection device 10, and single or multiple piping 8 of the chemical solution injection device 10, and more the spray nozzles 4 are arranged at each front-rear interval K formed by lesser rollers, e.g. every 1 and 2.

In addition, the so-called spray nozzle 4 in this listed document like the above description (multiple injection pipe type) is a hole and formed one in piping 8, and of course is included.

Further, for those shown in Fig. 2, the arrangement direction of piping 8 relative to wide direction D is the front-rear slant type, and the spray nozzle 4 formed in each piping 8 as shown in Fig. 6-(3) is also possible to be the one with gradually shift type in wide direction between each piping 8. On the other hand, this type of arrangement for the piping 8 along the front-rear transportation direction D is also possible(drawing is now shown). The spray nozzle 4 is as this.

The present invention is configured as the above explanation. Hereby, it is like the following. This chemical solution treatment equipment is used in, e.g. the manufacturing engineering of the printed circuit board. It comprises that the conveyer 2 which clamps the substrate of such printed circuit board A between the up-down multiple rollers 3 and wheel and transports them horizontally, the corresponding substrate of such printed circuit board A which is transported in conveyer 2, and the chemical solution injection device 10 which injects the chemical solution B as developing solution and etching solution (e.g. refer to Fig.1, Fig. 2, Fig.3).

The chemical solution injecting device 10 is arranged at front-rear interval K of the roller 3 and wheel of conveyer 2. It is oppositely arranged at limited up-down interval L for the corresponding substrate of such printed circuit board A.

And, for the chemical solution injection device 10, the multiple oppositely arranged spray nozzle 4 (e.g. refer to Fig. 5) covers the front-rear-left-right, or uses the oppositely arranged silt shaped orifice 13 to cover left-right (e.g. Fig.,4, further refer to Fig.1, Fig. 2, Fig. 3). Each spray nozzle 4 diffuses the chemical solution B in cone shape and wide end shape, and sprays then injects it. The silt shaped orifice 13 sprays the chemical solution B in straight-longitudinally curtain shape.

And, this chemical solution treatment equipment is characterized by that it has this conveyer 2 and chemical solution injection device 10, and it is arrange in the chemical solution tank 9 filled with chemical solution B.

Hereby, this chemical solution treatment equipment is related to the substrate of printed circuit board A which is transported in the tarried chemical solution B in the chemical solution tank 9 on the conveyer. The fresh chemical solution B is injected through the chemical injection device 10 that is in the tarried solution B of the same chemical solution tank 9. Via this, the fresh chemical solution B is injected in the tarried solution B but not in the environment.

The chemical solution treatment equipment as this, for the substrate of printed circuit board, the chemical processing and chemical solution treatment such as developing and etching is executed by using the chemical solution like developing solution and etching solution. As for the printed circuit board, the expected circuit G is formed on its outer surface.

Still, this chemical solution treat equipment has the chemical solution tank 9 in the upper portion of its processing chamber 11. The chemical managing reservoir is arranged in the lower portion of its processing chamber 11. The 21 in Fig.1, Fig. 2 is a cover of processing chamber 11.

And, for the substrate of printed circuit board A transported on the conveyer 2 which is put in the tarried chemical solution B of the chemical solution 9, the chemical solution B is injected from chemical injection device 10. And, the overflowed chemical solution B from the chemical solution tank 9 is flown down to the chemical solution injection device 10 for recovery. Further, the chemical solution B tarried in the chemical managing reservoir 12 is flown through the pipes such as pump 6, main pipe 7 and piping 8, press fed toward chemical injecting device 10 for recycling usage.

Thus, the chemical solution treatment equipment has the following first, second, third, fourth, fifth, sixth and seventh kinds.

Firstly, this chemical solution treatment equipment injects the fresh chemical solution B from the chemical solution injection device 10 such as slit shaped injection orifice 13 and spray nozzle 4 which is in the chemical solution B of the same chemical solution tank 9, to the transported substrate of printed circuit board A which is in the tarried chemical solution B of chemical solution tank 9 of the processing chamber 11.

Thus, the phenomena such as the density of the fresh chemical solution B at middle portion of printed circuit board A is low and the amount is small, and the density of the fresh chemical solution B at left-right portion of printed circuit board A is high and the amount is large can be avoided. Further, in the outer surface of surface and back surface of printed circuit board A, there will be no such phenomena as the chemical processing and chemical solution treatment like developing and etching by chemical solution which separately pass the middle portion and left-right side portion can be uniformed, the chemical processing and chemical solution treatment speed in the middle portion is slow in speeded or insufficient, and the chemical processing and chemical solution treatment at left-right side portion is too early, over advanced.

Secondly, for the above description chemical solution treatment equipment, the fresh chemical solution B is injected in the tarried chemical solution B and not in the environment. The phenomena as the injected chemical solution B flown to the left-right wide direction E (refer to Fig. 8-(2)) on the outer surface such as surface and back surface of the printed circuit board A can be really eliminated.

Therefore, the phenomena that the density of the fresh chemical solution in the middle portion of printed circuit board A is low and the amount is small, and the density of the fresh chemical solution at left-right side portion of printed circuit board A is high and the amount is large can be avoided. Further, in the outer surface of surface and back surface of printed circuit board A, there will be no such phenomena as the chemical processing and chemical solution treatment like developing and etching by chemical solution which separately pass the middle portion and left-right side portion can be uniformed, the chemical processing and chemical solution treatment speed in the middle portion is slow in speeded or insufficient, and the chemical processing and chemical solution treatment at left-right side portion is too early, over advanced.

Thirdly, also only for this chemical treatment device, the chemical solution tank 9 is mounted in the upper portion of processing chamber 11. And it is configured by the arrangement of the traditional used conveyer 2 which uses the roller 3 and wheel, and the chemical solution injection device 10 which uses multiple spray nozzle 4 or slot shaped orifice 13.

Generally, this chemical solution treatment equipment has comparably simple configuration. It can fulfill the uniformity in the above description first and chemical processing and chemical solution treatment easily and really.

Fourthly, the solution injecting device 10, such as the spray nozzle 4 and slit shaped orifice 13 in this chemical solution treatment equipment, is put in the chemical solution tank 9 and arranged between the front-rear interval K of rollers 3 and wheels of a conveyer 2. Further, corresponding to the transported printed circuit board A, e.g., it is oppositely arranged only within about 5mm.

Hereby, the phenomena that the spraying to the roller 3 and wheel of the conveyer 2 by the fresh chemical solution injected from the chemical solution injecting device 10 such as each spray nozzle 4 and slit shaped orifice 13, can be really avoided.

Through this chemical solution treatment equipment, the injected fresh chemical solution B to the outer surface of surface and back surface of transported printed circuit board in the chemical solution B tarried in the chemical solution tank 9, can directly, effectively be injected along with impact. Further, the chemical processing and chemical solution treatment of developing and etching can be totally smoothly executed without particular slow in speed, thus the processing capability can be upgraded.

Fifthly, the printed circuit board A put in this chemical solution treatment equipment is clamped between the up-down each rollers 3 and wheels of conveyer 2 for transportation, and use the floating force of the chemical solution B tarried in chemical solution tank 9 to transport the PCB between the front-rear each roller 3 and front-rear-left-right wheel under floating status.

Through this, recently, there are advancements in very fineness, flexibility for printed circuit board A. While it is put in front-rear each roller 3 and front-rear-left-right wheel, the situation as a slightly concave-bent shaped bending due to the weight of the tarried chemical solution B injected on the surface can be prevented.

The slightly concave-bent shaped bending as this, the reverse bending will not occur. Thus, the printed circuit board can expect to be transported smoothly without the obstacles.

Sixthly, according to this chemical solution treatment equipment, the fresh chemical solution B is injected from the chemical solution injecting device 10, such as the spray nozzle 4 and slit shaped orifice 13 in the chemical solution B which is stored in the same tank 9, to the transported printed circuit board A in the chemical solution B which is stored in the same tank 9.

Hereby, while injecting the chemical solution B in the environment, the gasification of the injected chemical solution B is really avoided. By utilizing this chemical treatment equipment, it can really prevent the occurrence of the hazardous gas from the injected chemical solution B. Through the gasification prevention as this, this part of processing capability is also upgraded.

Seventhly, while using the slit shaped orifice13 of chemical solution injecting device 10 shown in Fig.1, Fig. 2, Fig.3, Fig.4, Fig. 6(2), it particularly has the excellent uniformity and processing capability in the chemical processing and chemical solution treatment.

That is, while using spray nozzle 4 as the chemical injecting device 10 shown in Fig. 5, Fig. 6-(1), Fig. 2, the chemical solution B is diffused in cone shape of gradually widened shape and injected through each spray nozzle 4. If there is non-uniform injection to the outer surface of printed circuit board A, it is easy to create the difference between interior and exterior as density, injection pressure and injection amount. κlt creates the locations of square angled injection to the printed circuit board A, and the locations of angled injection from side. From this aspect, it is difficult to become totally uniformed injection, the total injection pressure becomes low owing to diffusing and the impact becomes insufficient, thus the processing capability become low.

Corresponding to this, while using the slit shaped orifice 13 as the chemical solution injecting device 10, they are arranged to cover the wide direction E. The chemical solution B barely diffuses toward the full width of the outer surface of printed circuit board A. Owing to the injection in slightly flat curtained type without diffusion straightly and vertically, (1) there is no desultoriness of injected chemical solution B and can be unified, (2) there is no accompanying of injection angle for chemical solution B, (3) it can be injected directly with high shooting pressure.

Further, while using the slit shaped orifice 13 as the chemical solution injecting device 10, the uniformity and processing capability of chemical processing and chemical solution treatment can be upgraded.

However, for the conveyer 2 and chemical solution injection device 10 according to the present invention shown in drawing example, the total arrangement is, but it is not always necessary.

Generally, the conveyer 2 is very essential for the transportation of substrate of printed circuit board A in the chemical solution B of tank 9. The solution injection device 10 as spray nozzle 4 and slit shaped injecting orifice in the chemical solution B of tank 9 are also very essential to emit a jet of the fresh chemical solution B to the substrate of printed circuit A. Part of the conveyer 2 and solution injection device 10 can also be arranged in the environment and not in the chemical solution B of the tank 9.

The chemical solution treatment equipment such as developing and etching devices related to the present invention is described as above. In the chemical solution tank, the printed circuit board is transported through a conveyer, then the fresh chemical solution is injected via the chemical injection device such as spray nozzles or slit-typed injecting orifices. Therefore, the following effects can be achieved.

Firstly, it eliminates the tarry of chemical solution and improves the uniformity of chemical processing and chemical solution treatment. That is, according to this chemical solution treatment equipment, corresponding to the substrate of the transported printed circuit board in the chemical solution of a tank, the fresh chemical solution B has been injected from the chemical solution injecting device in the chemical solution which is stored in the same tank. The chemical solution has been injected uniformly on the outer surface of the substrate of the transported printed circuit board. Thus, it can really prevent the chemical solution offset-tarried on the upper surface (the above upper surface) of the middle portion.

Generally, for the chemical solution treatment equipment of a foregoing conventional example, the chemical solution is injected in the environment, the tarry of the injected dense chemical solution in the upper middle portion of a substrate of the printed circuit board can be really dismissed without encumbering the replacement of the injected fresh chemical solution, and the function degradation and tarry of the old chemical solution can be debarred.

Then, according to the chemical solution treatment equipment of the present invention, the upper middle portion, two side portions of upper surface, and the outer surface of back surface of the printed circuit board has totally be unified through the chemical processing and chemical solution treatment such as developing and etching, and there will be no slow in speed or insufficiency of the chemical processing and chemical solution treatment on the upper middle portion.

Secondly, it eliminates the flow toward the left-right wide direction, and this aspect also improves the uniformity of chemical processing and chemical solution treatment.

That is, according to the above description chemical solution treatment equipment, for the substrate as the transported printed circuit board in the chemical solution of a tank, the fresh chemical solution has been injected from the chemical solution injecting device in the chemical solution which is stored in the same tank. The chemical solution has been injected uniformly on the outer surface of the substrate of the transported printed circuit board. Thus, it can really prevent the chemical solution to flow in the left-right wide direction on the outer surface of the upper and back surfaces.

In general, in the chemical solution treatment equipment of a foregoing conventional example where the chemical solution is injected in the environment, the injected chemical solution flows in the left-right wide direction of the outer surface of the substrate of the printed circuit board and flows down from both left and right sides. The flown out is really removed by the executing of this injection in the chemical solution. Hereby, for the substrate of the printed circuit board, low density and small amount of the fresh chemical solution in middle side and the high density and large amount of the fresh chemical solution in both left and right sides can also be prevented.

Then, about the outer surface of the substrate of the printed circuit board, the chemical processing and chemical solution treatment of developing and etching will become totally unified by the chemical solution treatment equipment of the present invention; the speed slow in speed in the chemical processing and chemical solution treatment of the outer surface of middle portion, and insufficiency; and the earliness and over improvement in the chemical processing and chemical solution treatment of two side portions will be solved, while the chemical solution passes through the middle portions and left-right two side portions.

By the chemical solution treatment equipment according to the present invention, the slow in speed of chemical processing and chemical solution treatment, insufficiency and over-excessiveness in the above description first and second kinds will not occur and the uniformity in chemical processing and chemical solution treatment can be achieved.

Thereby, with the manufacturing process of printed circuit board, about the formation of circuits on the outer surfaces of two sides of PCB (printed circuit board), the totally uniformity in the circuit width can be achieved even in the super fine circuit width. Generally, the damage in the uniformity of the chemical processing and chemical solution treatment, and the occurrence of phenomena as unbalance, accumulation and separation in these insufficiency and excessiveness can be prevented. The occurrence of situations as the wider locations and narrower locations in the circuit width can be prevented; and the in-uniformity of circuit width and the disappearance of circuits can be really avoided.

In particular, the CSP, PBGA of package windings of semiconductor chips contains in the printed circuit board. The progress in the super fineness, high precision and high density of circuit is significant. By the chemical solution treatment equipment according to the present invention, it is possible to form a stable circuit width with uniformity even in a super fine circuit width. This means a lot that the limit value of circuit width can be significantly rewritten. For example, by the chemical solution treatment equipment of the present invention, even the printed circuit board with a circuit width of 20 microns and space between circuits of 30 microns can be manufactured easily.

Recently, corresponding to the printed circuit board with small size, fineness, super thinness and flexibility, for the super thinness in the thickness of copper foils which are used in circuit formation, the meaning of this chemical solution treatment equipment of present invention is particularly apparent by just viewing from the points that in-uniformity of chemical processing and chemical solution treatment, the easy occurrence of in-uniformity in circuit width and the disappearance of circuits.

Thirdly, furthermore, it can realize the aspects of excellence in the equipment cost and layout space.

That is, this chemical solution treatment equipment can simply and really realize better uniformity in the above description 1st and 2nd chemical processing and chemical solution treatment by a simple structure set in the chemical solution tank, while comparing with the conveyer which using the conventional roller and wheel and the chemical solution injecting device which using the spray nozzle and slit shaped injecting orifice.

Also, the above description traditional chemical solution treatment equipment can save up to 30% of the total equipment cost and is very excellent in the equipment cost aspect while comparing the situations such as each nozzle attached to the left-right swung mechanism and oscillation mechanism, and the transported printed circuit board attached to the up-down reverse mechanism and left-right turn mechanism. Further, compared with the traditional chemical solution treatment equipment, it is also good in the setup space aspect.

Fourthly, further, the chemical processing and chemical solution treatment capability is upgraded because of no chemical solution spraying from the roller and wheel of the conveyer.

That is, in the chemical solution treatment equipment, the injecting devices as spray nozzles and slit shaped injecting orifices in the chemical solution tank are arranged in front-rear intervals between rollers and wheels of the conveyer. As for the substrate of the printed circuit board, it is only arranged oppositely in up-down intervals.

Therefore, in the above description chemical solution treatment equipment of the conventional example where the chemical solution is injected in the environment, the chemical solution spraying from the roller and wheel of the conveyer in the environment, which is injected from each spray nozzle, can be really avoided.

The chemical solution injecting device of the present invention can directly and effectively spray the fresh injected chemical solution and impact on the outer surface of the substrate of the printed circuit board which is transported and located in the chemical solution of the chemical solution tank, thus can smoothly renew the chemical solution on the outer surface of the substrate of the printed circuit board.

Thus, the chemical processing and chemical solution treatment of developing and etching of the outer surface of the substrate of the printed circuit board can be executed without particular slow in speed, such that the processing capability, production efficiency is upgraded, and also the cost performance.

Fifthly, the bending up of the substrate of the printed circuit board is also eliminated to realize the smooth transportation.

That is, this chemical solution treatment equipment can spray the chemical solution from the chemical solution injecting devices, such as spray nozzles and slit shaped injecting orifices in the chemical solution of the same chemical solution tank, to the corresponding substrate of transported printed circuit board in the chemical solution of the same chemical solution tank of this chemical solution treatment equipment. Hereby, the weight of tarried chemical solution which is injected and the bending up of from the substrate of the printed circuit board is really eliminated.

In general, the situation as the substrate of the printed circuit board which recently progresses in extremely thinness and flexibility, located between front-rear rollers and front-rear-left-right wheels, and is slightly bent concavely due to the weight of tarried chemical solution which is injected, can be avoided, and there is no reverse bending in the bending ends.

The substrate of the printed circuit board located in the chemical solution injecting device of the present invention is clamped between each roller and wheel of the conveyer in the chemical solution of the chemical solution tank, and then is transported along with the front-rear rollers and front-rear-left-right wheels under the half floating status due to the floating force of the chemical solution in the chemical solution tank. Hereby, the substrate of the printed circuit board slightly bent concavely due to the weight has no reverse bending, and can be transported smoothly as expected without obstacles,

Therefore, the chemical processing and chemical solution treatment of the substrate of the printed circuit board can be smoothly executed, such that it prevents the occurrence of defects, the staying becomes better and the productivity is upgrade.

Sixthly, it prevents the vaporization of the injected chemical solution. That is, since the fresh chemical solution is injected from the chemical solution injecting device in the chemical solution of the same chemical solution tank to the corresponding substrate of transported printed circuit board in the chemical solution of the chemical solution tank of this chemical solution treatment equipment, the gasification of the injected chemical solution is really eliminated.

Generally, the developing chemical solution and etching chemical solution diffused, sprayed and injected from each spray nozzle of the chemical solution injecting devices, such as the foregoing traditional chemical solution treatment equipment will not be gasified in large amount. For example, the gasification of the vaporized oxidizer in the chemical solution is avoided.

As this, the exhausting mechanism which is used for exhausting the poisonous gas from the interior of processing chamber to its exterior is not necessary because of no occurrence of the poisonous gas which is hazardous to human body, such that the processing capability, production efficiency is upgraded, and also the cost performance.

Furthermore, because the gasification of this injected chemical solution has been prevented, the consumption of this part of chemical solution can be avoided. The total speed of the chemical processing and chemical solution treatment as developing and etching can be improved, and the processing capability, production efficiency is upgraded, and also the cost performance.

As this, the effect of the present invention is very prominent by solving all the existing subjects of this traditional example.

## Claims

1. Chemical solution treatment equipment for chemical processing of a transported substrate (A) by jetting a chemical solution (B), characterized in that the equipment comprises:
a tank (9) arranged to be filled with the same solution as the chemical solution (B) to be jetted;
a conveyor (2), at least a part of which is mounted in the tank (9) so as to be in the chemical solution (B) in the tank (9), to transport the substrate (A); and
a device (10) for jetting chemical solution (B) toward the substrate (A), mounted in the tank (9) so as to be in the chemical solution (B) in the tank (9).

2. The equipment of claim 1, wherein the conveyor (2) is provided with rollers (3) and/or wheels arranged on either side of the path of the substrate (A) for clamping the extensive side of the substrate (A) and transport the substrate (A); and
at least one device (10) for injecting the chemical solution (B) is arranged in the intervals between rollers (3) and/or wheels of the conveyor (2), and there is a very small gap between the device and the rollers (3) or wheels.

3. The equipment of claim 1 or 2, wherein jetting device (10) comprises many fixed spray nozzles (4), characterized in that:
the spray nozzles (4) are arranged alternately on either side of the path of the substrate (A) with respect to the transporting direction, and
the spray is arranged to cover a large area of the whole path in the transporting and transverse directions (D,E) by spacing the said spray nozzles (4) between the rollers (3) and/or wheels.

4. The equipment of claim 1 or 2, wherein the jetting device (10) comprises slit shaped injection orifices (13), characterized in that:
slit injection orifices (13) mounted normally to the transported substrate (A) are arranged to extend transversely on either side of the path of the transported substrate (A).

5. The equipment of claim 4 is characterized in that:
at least one slit shaped injection orifice (13) of this equipment is directed transversely across the substrate (A), so as to form a flat curtained jet without diffusion, substantially normal to the extensive surface of the substrate (A).

6. The equipment of any of the preceding claims, wherein the said tank (9) is mounted in an upper position and a chemical control tank (12) is in a lower position, characterized in that:
it is arranged such that the chemical solution (B) injected from the jetting device (10) is passed over the outer surface of said substrate (A), then the overflow from tank (9) flows down to the chemical control tank (12); and
said chemical solution (B) stored in the chemical control tank (12) is pumped to the jetting device (10) of the chemical solution treatment equipment via pump (6) and pipe (7) for recycling usage.

7. The equipment of any of the preceding claims, wherein there are jetting devices (10) and rollers (3) and or wheels above and below the transporting path.

8. The equipment of any of the preceding claims, suitable for chemical processing of a copper clad laminate used for the manufacture of printed circuit boards.

9. Chemical solution treatment equipment substantially as herein described with reference to Figures 1, 3 and 4, or 2, 5 and 7, or 6 or 8 or 9 of the accompanying drawings.

10. The equipment of any of the preceding claims wherein the tank (9) is filled with chemical solution (B).

11. The equipment of claim 9 or 10, and in use for manufacturing process of printed circuit boards;
the substrate (A) being a copper clad laminate which is to have circuits etched on its surface; and
the chemical solution (B) is a developing or etching chemical solution.
